Europäisches Patentamt

European Patent Office

Office européen des brevets

(19)

(11) Veröffentlichungsnummer: **0 339 526**
**A1**

## (12) EUROPÄISCHE PATENTANMELDUNG

(21) Anmeldenummer: 89107301.7

(22) Anmeldetag: 22.04.89

(51) Int. Cl.⁴: **B01D 53/34 , B01D 57/00 , C23C 16/00 , A62D 3/00 , //B01J3/00**

(30) Priorität: 28.04.88 DE 3814388

(43) Veröffentlichungstag der Anmeldung:
02.11.89 Patentblatt 89/44

(84) Benannte Vertragsstaaten:
CH DE FR GB IT LI SE

(71) Anmelder: **Kernforschungsanlage Jülich Gesellschaft mit beschränkter Haftung**
**Postfach 1913**
**D-5170 Jülich 1(DE)**

(72) Erfinder: **Esser, Hans Günter, Dr.**
**Kapellenstrasse 13**
**D-5172 Linnich-Ederen(DE)**
Erfinder: **Winter, Jörg, Dr.**
**Auestrasse 36**
**D-5162 Niederzier(DE)**
Erfinder: **Reimer, Harry**
**Alte Rodung 156**
**D-5180 Eschweiler(DE)**
Erfinder: **Wienhold, Peter, Dr.**
**Rurallee 7**
**D-5172 Linnich(DE)**

(54) **Mit flüchtigen, toxischen Verbindungen arbeitende Niederdruckanlagen.**

(57) Bei Vakuumanlagen, die mit flüchtigen toxischen Verbindungen von pyrolytisch abscheidbaren Elementen arbeiten oder mit Verbindungen, die pyrolytisch in unschädliche Bestandteile zersetzt werden können, kann die Ansammlung von toxischen Verbindungen im Arbeitsmedium der Vorvakuumpumpe oder die Abgabe an die Umgebung mittels eines im Niederdruckbereich vor der Pumpe vorgesehenen Zersetzers vermieden werden, dessen Oberflächen auf Zersetzungstemperatur (von z. B. bis 1500° C) zu bringen sind und der durch zumindest eine auswechselbare Packung von Füllmassen, wie insbesondere Edelstahlspänen gebildet wird, die einerseits das Saugvermögen nicht wesentlich herabsetzen, deren Oberflächen aber andererseits einen mittleren Abstand in Gasdurchgangsrichtung aufweisen, durch den eine turbulente Strömung erzwungen wird, so daß ein "Schlupf" toxischer Moleküle durch den Zersetzer ohne Wandkontakt vermieden wird. Zweckmäßig sind zumindest 2 abwechselnd zu betreibende Zersetzer mit auswechselbarer Füllung, die insbesondere durch Rohre von 10 bis $10^3$ cm Länge und 1 bis 100 cm Durchmesser gebildet werden, die mit Spänen von mittlerem Durchmesser um 1 bis 2 mm gefüllt sind und auf Temperaturen im Bereich von 300 bis 900° C aufgeheizt werden.

## Mit flüchtigen, toxischen Verbindungen arbeitende Niederdruckanlagen

Die Erfindung bezieht sich auf mit flüchtigen, toxischen wärme-zersetzlichen Verbindungen, insbesondere von pyrolytisch abscheidbaren Elementen arbeitende Niederdruckanlagen mit Vorvakuumpumpe und einem der Pumpe vorgeschalteten Zersetzer im Niederdruckbereich mit auf Zersetzungstemperatur zu bringenden Oberflächen.

Anlagen, in denen flüchtige toxische Verbindungen, wie z. B. Borane (vorzugsweise Diboran), Silane, Arsenwasserstoff, Phosphine, Galliumarsenid, Lithiumbuthylat oder Mischungen derselben umgesetzt werden oder entstehen oder als Beimischung in einem Trägergas auftreten, arbeiten im allgemeinen mit Unterdruck um ein irreguläres Entweichen dieser toxischen Verbindungen zu vermeiden. Sie haben daher zumindest eine Vorvakuumpumpe und es ist üblich, am Ausgang derselben für eine Absorption oder Unschädlichmachung der toxischen Stoffe zu sorgen.

Im Pumpenöl sammelt sich daher toxisches Material an, woraus Probleme beim Ölwechsel und der Beseitigung desselben resultieren.

Es ist daher bereits eine Anordnung bekannt, bei der eine chemische Abscheidung insbesondere von SiO₂ aus silanhaltigem Gas im Vakuum vor der Vorpumpe an aufgeheizten Flächen vorzugsweise unter UV-Einstrahlung und Sauerstoffzufuhr erfolgt. Die dafür vorgesehene Kammer entspricht im wesentlichen der eigentlichen Reaktionskammer und umfaßt eine Serie von Prallflächen, die auf mäßige Temperaturen (z. B. 75 - 300 °C) aufgeheizt werden.

Eine solche Anordnung ist vergleichsweise kompliziert und im wesentlichen nur für den speziellen Fall der Halbleiterfertigung vorgesehen.

Ziel der Erfindung ist daher eine möglichst einfache, effektive und breit anwendbare Anordnung, durch die flüchtige toxische Verbindungen mit abscheidbaren Elementen durch pyrolytische Zersetzung und Abscheidung vor der Vorpumpe unschädlich gemacht werden.

Zu diesem Zweck ist die erfindungsgemäße Anlage der eingangs genannten Art dadurch gekennzeichnet, daß der Zersetzer zumindest eine auswechselbare Packung von Füllmassen umfaßt, die das Saugvermögen nicht wesentlich herabsetzen und deren Oberflächen einen mittleren Abstand in Gasdurchgangsrichtung aufweisen, durch den eine turbulente Strömung erzwungen wird.

D. h., gemäß der Erfindung werden durch thermische Zersetzung unschädlich zu machende flüchtige, toxische Verbindungen schon im Niederdruckbereich, d. h. vor dem Eingang der Vorvakuumpumpe in unschädliche gasförmige oder feste Stoffe umgewandelt, so daß eine Kontamination des Pumpenöls entfällt wobei der an sich bekannte Effekt pyrolytischer Abscheidung von Elementen an heißen Flächen (siehe z. B. DE-AS 1 267 054) ausgenutzt wird.

Als Zersetzer werden insbesondere mit Spänen, Waffelgitter, Körnern oder anderen Füllmassen versehene Leitungsstrecken vorgesehen, die das Saugvermögen der Pumpe nur unwesentlich beeinträchtigen sollen. Als Materialien kommen hitzebeständige inerte Materialien in Betracht wie Stahl, Edelstahl, Keramik, Graphit etc. Partikelgrößen von 1 - 10 mm sind dabei zweckmäßig.

Der vor dem Eingang der Vorvakuumpumpe angeordnete Zersetzer befindet sich insbesondere in einer Vorvakuumleitung zwischen Hauptvakuum nit Turbomolekularpumpe (TMP) und den Vorvakuumpumpen (z. B. Roots-oder Drehschieberpumpen). Die Geometrie des Zersetzers bzw. der Füllmassen ist so ausgebildet daß die mittlere freie Weglänge der toxischen Moleküle größer ist als der mittlere Abstand der heißen Wandelemente bzw. Oberflächen in Gasströmungsrichtung, wodurch eine turbulente Gasströmung erzwungen wird. Auf diese Weise kann kein Molekül passieren, ohne an den heißen Wandungen bzw. Oberflächen zersetzt zu werden. Die obere Grenze des Arbeitsbereichs liegt bei etwa 0,1 mbar, wobei vorzugsweise im Durchstrom der zu zersetzenden toxischen Stoffe gearbeitet wird.

Die Zersetzer umfassen zweckmäßigerweise auswechselbare Packungen von Edelstahlspänen in einem Stahlrohr, wobei speziell Rohrlängen von 10 bis 10³ cm und Durchmesser von 1 bis 100 cm zweckmäßig sind und Späne deren mittlerer Durchmesser in der Gegend von 1 bis 2 mm liegt. Vorzugsweise werden Rohrlängen von 20 - 100 cm und Durchmesser von 5 - 20 cm vorgesehen.

Allgemein sind Zersetzungstemperaturen an den Zersetzerwänden bis etwa 1500 °C, insbesondere von 300 bis 900 °C zweckmäßig.

Um einen kontinuierlichen Betrieb zu gewährleisten werden zumindest zwei Zersetzer abwechselnd betrieben, um so eine Überbrückung von Auswechselungsarbeiten zu ermöglichen.

Nachfolgend wird die Erfindung anhand eines Ausführungsbeispiels näher beschrieben, bei dem auf die angefügte Zeichnung Bezug genommen wird, die zwei wechselseitig zu betreibende beheizte Edelstahlrohre mit Packungen zeigt, die mit Edelstahlspänen gefüllt sind. Eine jeweils vorgesehene Heizung ermöglicht die Aufheizung auf Zersetzungstemperatur. Ventile vor und hinter den Zersetzern ermöglichen den wechselseitigen Betrieb um jeweils "verbrauchte" Packungen durch frische Packungen ersetzen zu können.

Eine solche Zersetzeranordnung wurde wie folgt betrieben:

Beispiel

Die Zersetzer, wie vorstehend beschrieben, wurden jeweils durch ein Edelstahlrohr von 0,5 m Länge und 63 mm Durchmesser (Wanddicke 2 mm) gebildet, welches eine mit Edelstahlspänen gefüllte Packung enthielt. Durch Heizung von außen wurde in der Rohrmitte eine Temperatur von 700 °C erzielt. Toxisches Diboran in einer Beimengung von 10 % zu einer Mischung von 10 % Methan und 80 % Helium durchströmte die Packung mit einem Druck von $5 \times 10^{-2}$ mbar und wurde vollständig zersetzt, ehe es die Vorpumpe erreichte. Nach einem 7-stündigen Versuch konnten im Pumpenöl keine Spuren von Diboran gefunden werden. Das Saugvermögen der Vorpumpe ($\sim$ 10 mbar l s$^{-1}$) war nicht wesentlich herabgesetzt.

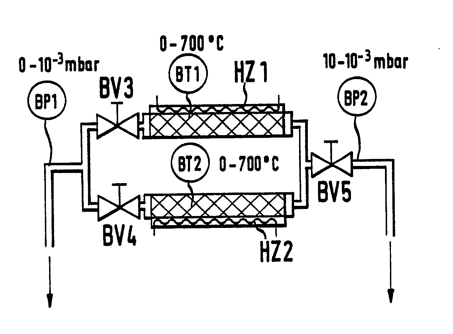

**Ansprüche**

1. Mit flüchtigen, toxischen wärme-zersetzlichen Verbindungen, insbesondere von pyrolytisch abscheidbaren Elementen arbeitende Niederdruckanlagen mit Vorvakuumpumpe und einem der Pumpe vorgeschalteten Zersetzer im Niederdruckbereich mit auf Zersetzungstemperatur zu bringenden Oberflächen,
**dadurch gekennzeichnet,**
daß der Zersetzer zumindest eine auswechselbare Packung von Füllmassen umfaßt, die das Saugvermögen nicht wesentlich herabsetzen und deren Oberflächen einen mittleren Abstand in Gasdurchgangsrichtung aufweisen, durch den eine turbulente Strömung erzwungen wird.

2. Anlagen nach Anspruch 1,
**gekennzeichnet durch**
eine beheizte auswechselbare Packung von Edelstahlspänen in einem Edelstahlrohr als Zersetzer.

3. Anlagen nach Anspruch 2,
**gekennzeichnet durch**
eine Rohrlänge von 10 - $10^3$ cm und einen Durchmesser von 1 - 100 cm sowie Späne von mittlerem Durchmesser um 1 - 2 mm.

4. Anlagen nach einem der vorangehenden Ansprüche, **gekennzeichnet durch**
eine Beheizung der Oberflächen auf 300 - 900 °C.

5. Anlagen nach einem der vorangehenden Ansprüche,
**gekennzeichnet durch**
zumindest zwei abwechselnd zu betreibende Zersetzer mit auswechselbarer Füllung.

## EINSCHLÄGIGE DOKUMENTE

EP 89107301.7

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | DE - A1 - 3 432 033 <br> (FRIEDRICH-SCHILLER-UNIVERSI-TÄT) <br> * Patentansprüche * <br> -- | 1 | B 01 D 53/34 <br> B 01 D 57/00 <br> C 23 C 16/00 <br> A 62 D  3/00// <br> B 01 J  3/00 |
| A | US - A - 4 556 584 <br> (SARKOZY) <br> * Patentansprüche * <br> -- | 1 | |
| D,A | DE - B - 1 267 054 <br> (UNION CARBIDE) <br><br> ---- | | |

| RECHERCHIERTE SACHGEBIETE (Int. Cl.4) |
|---|
| B 01 D <br> C 23 C <br> A 62 D <br> B 01 J |

Der vorliegende Recherchenbericht wurde für alle Patentansprüche erstellt.

| Recherchenort | Abschlußdatum der Recherche | Prüfer |
|---|---|---|
| WIEN | 26-07-1989 | BECKER |